# EUROPÄISCHE PATENTSCHRIFT

(11) **EP 0 374 235 B1**
(45) Veröffentlichungstag und Bekanntmachung des Hinweises auf die Patenterteilung: **19.10.1994**
(21) Anmeldenummer: 89906753.2
(22) Anmeldetag: 26.05.1989
(51) Int. Cl.: H03L 7/14, G11B 19/28

(54) **PHASENREGELKREIS**
PHASE-CONTROL CIRCUIT
CIRCUIT DE REGULATION DE PHASE

(30) Priorität: 16.06.1988 DE 3820477
(43) Veröffentlichungstag der Anmeldung: 27.06.1990
(73) Patentinhaber: Deutsche Thomson-Brandt GmbH, 78003 Villingen-Schwenningen (DE)
(72) Erfinder: STORZ, Dieter, D-7233 Lauterbach (DE); BAAS, Dieter, D-7640 Kehl (DE)
(86) Internationale Anmeldenummer: EP8900590
(87) Internationale Veröffentlichungsnummer: WO8912932

(56) Entgegenhaltungen:
- EP-A- 0 049 136
- GB-A- 2 128 780
- Patent Abstracts of Japan, Band 10, Nr. 177 (P-470)(2233), 21 Juni 1986 & JP-A-61-24055
- Patent Abstracts of Japan, Band 9, Nr. 105 (P-354)(1828), 9. Mai 1985 & JP-A-59-227069

## Beschreibung

Die Erfindung betrifft einen Phasenregelkreis, bei dem der Ausgang eines ersten Phasenvergleichers, in dem die Istfrequenz mit der Bezugsfrequenz verglichen wird, mit dem Eingang eines ersten Reglers verbunden ist, dessen Ausgang mit dem Eingang eines Nachlaufoszillators verbunden ist.

In U.Tietze, Ch. Schenk, Halbleiter-Schaltungstechnik, 4. Auflage, Springer-Verlag, 1978 ist auf Seite 683 - 684 ein Phasenregelkreis, eine sogenannte phase-locked-loop beschrieben.

Phasenregelkreise, häufig mit PLL abgekürzt, dienen z.B. in CD-Spielern dazu, aus dem EFM-Signal, dem nach dem eight-to-fourteen-Code codierten und optisch von der CD-Platte gelesenen Datensignal, das Synchronsignal zur Regelung der Drehzahl des Plattenantriebs zu gewinnen. Ein Beispiel einer solchen Regelung wird im Dokument GB-A- 2 178 780 beschrieben. Die Regelung der Drehzahl des Plattenantriebs ist nötig, um eine gleichbleibenbe Bitrate im Datenfluß zu gewährleisten.

Ein erster Nachteil besteht nun darin, daß bei der Produktion eines CD-Spielers der Nachlaufoszillator des Phasenregelkreises durch Abgleich von Hand auf die Bezugsfrequenz eingestellt werden muß, denn Einstellarbeiten von Hand sind stets zeitaufwendig und teuer.

Ein zweiter Nachteil zeigt sich jedoch erst während des Betriebs eines CD-Spielers, wenn sich durch Temperaturdrift oder durch Alterung der Bauteile der PLL im Laufe der Zeit bedingt die Parameter der einzelnen Bauteile ändern und zu einer allmählichen zunächst kaum wahrnehmbaren Verschlechterung der Tonwiedergabe führen.

Es ist daher Aufgabe der Erfindung, bei einem Phasenregelkreis den nachteiligen Abgleich von Hand zu vermeiden und für einen von Alterung der Bauteile und von Temperaturdrift weitestgehend unabhängigen störungsfreien Betrieb zu sorgen.

Die im Anspruch 1 definierte Erfindung löst diese Aufgabe dadurch, daß der Ausgang eines zweiten Reglers mit dem Eingang des Nachlaufoszillators verbunden ist, daß der Ausgang des Nachlaufoszillators mit dem ersten Eingang eines zweiten Phasenvergleichers verbunden ist, dessen zweiten Eingang die Bezugsfrequenz zugeführt wird und dessen Ausgang mit dem Eingang des zweiten Reglers verbunden ist, daß zum automatischen Abgleich des Phasenregelkreises der erste Regler vom Nachlaufoszillator getrennt wird, daß der zweite Regler den Wert an seinem Ausgang so lange ändert, bis die Frequenz am Ausgang des Nachlaufoszillators mit der Bezugsfrequenz übereinstimmt, daß nach dem Abgleich der zweite Regler diesen Wert unabhängig vom Wert am Ausgang des zweiten Phasenvergleichers beibehält und der erste Regler wieder mit dem Eingang des Nachlaufoszillators verbunden wird.

Es zeigen
- Figur 1: ein erstes Ausführungsbeispiel
- Figur 2: ein zweites Ausführungsbeispiel
- Figur 3: ein drittes Ausführungsbeispiel
- Figur 4: ein viertes Ausführungsbeispiel der Erfindung.

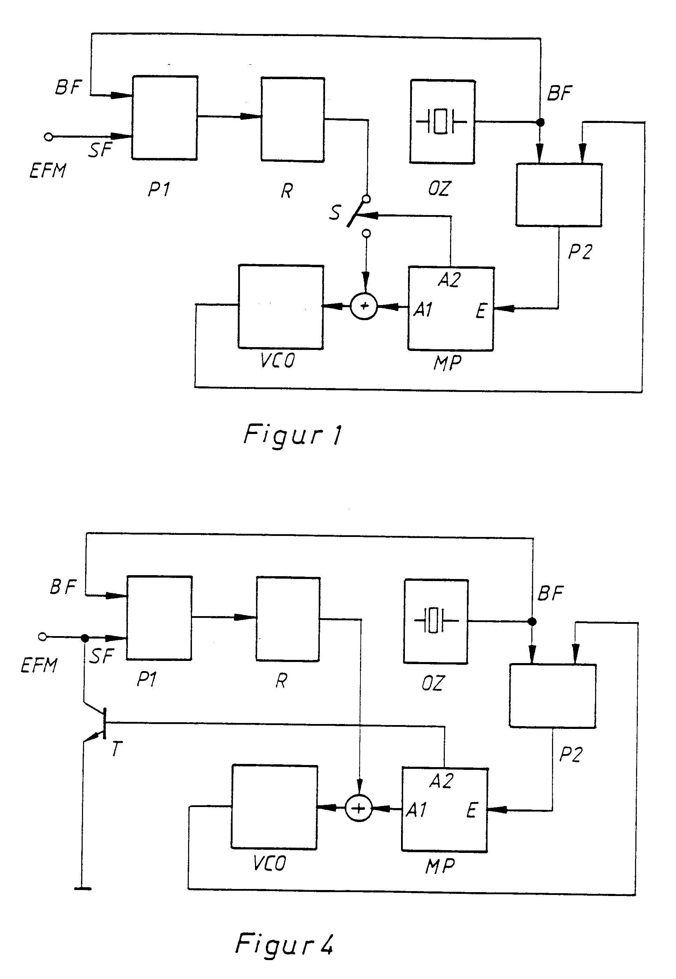

Anhand des in Figur 1 gezeigten Ausführungsbeispieles wird die Erfindung nun zuerst beschrieben und anschießend erläutert.

In der Figur 1 wird das EFM-Signal dem ersten Eingang eines Phasenvergleichers P1 zugeführt, dessen Ausgang mit dem Eingang eines ersten Reglers R verbunden ist. Der Ausgang eines Quarzoszillators OZ, der die Bezugsfrequenz BF erzeugt, ist mit dem zweiten Eingang des Phasenvergleichers P1 und eines weiteren Phasenvergleichers P2 verbunden, dessen erster Eingang mit dem Ausgang eines Nachlaufoszillators VCO verbunden ist. Der Eingang des Nachlaufoszillators VCO, beispielsweise ein spannungsgesteuerter Oszillator, ist mit dem ersten Eingang A1 eines als zweiten Regler vorgesehenen Mikroprozessors MP und über einen steuerbaren Schalter S mit dem Ausgang des ersten Reglers R verbunden. Der Eingang E des Mikroprozessors MP ist mit dem Ausgang des Phasenvergleichers P2 verbunden. Der Steuereingang des steuerbaren Schalters S ist mit dem zweiten Ausgang A2 des Mikroprozessors MP verbunden.

Zum Abgleich des Phasenregelkreises öffnet der Mikroprozessor MP den steuerbaren Schalter S, so daß der Ausgang des ersten Reglers (R) vom Eingang des Nachlaufoszillators OZ getrennt wird, und ändert nun die Spannung an seinem Ausgang A1 so lange, bis die Frequenz am Ausgang des spannungsgesteuerten Oszillators VCO mit der Bezugsfrequenz BF des Quarzoszillators OZ übereinstimmt. Anschließend behält der Mikroprozessor MP diese Spannung an seinem Ausgang A1 bei und schließt den steuerbaren Schalter S. Der Phasenregelkreis ist jetzt abgeglichen und betriebsbereit.

Der automatische Abgleich des Phasenregelkreises kann z.B. gemäß Unteranspruch 5 jedesmal beim Einschalten des CD-Spielers vorgenommen werden. Er kann aber auch, wie in den Unteransprüchen 6 und 7 angegeben, jedesmal vor dem Abspielen einer neuen CD-Platte oder wenn keine Daten wiedergegeben werden, beispielsweise in einer Pause zwischen zwei Musikstücken, durchgeführt werden. Auch wenn sich die Abtastvorrichtung des CD-Spielers in einer Warteposition befindet, weil die Bedienperson beispielsweise ein Programm in den CD-Spieler eingibt,kann der Abgleich erfolgen. Bei zwei weiteren Ausführungsbeispielen erfolgt der Abgleich, wenn die Fehlerrate im Datensignal einen vorgebbaren Schwellwert übersteigt oder wenn der CD-Spieler vollkommen ausfällt. Beim Spurspringen läßt sich der Abgleich ebenfalls durchführen.

Wenn der Abgleich bei bereits laufendem Plattenantrieb, z.B. zwischen zwei Musikstücken, durchgeführt wird, wird bei einem weiteren Ausführungsbeispiel die zuletzt vor dem Abgleich eingestellte Drehzahl des Plattenantriebs für die Dauer des Abgleichs beibehalten. Diese Maßnahme hat bei einem System, das mit einer konstanten Bahngeschwindigkeit arbeitet - ein sogenanntes constant velocity system - den Vorteil, daß die Drehzahl des Plattenantriebs nach dem Abgleich in der Nähe des Sollwertes liegt.

Selbstverständlich ist eine Kombination aller in den Unteransprüchen 4 - 8 beschriebenen Merkmale möglich.

Wenn ein CD-Spieler mit dem erfindungsgemänen Phasenregelkreis ausgerüstet ist, entfällt nicht nur der lästige Abgleich von Hand bei der Produktion, sondern es wird auch wegen des häufig vorgenommenen Neuabgleichs für eine gleichbleibend gute Tonwiedergabe gesorgt, weil Änderungen der Parameter einzelner Bauteile infolge Alterung oder infolge Temperaturschwankungen bei jedem Neuabgleich kompensiert werden.

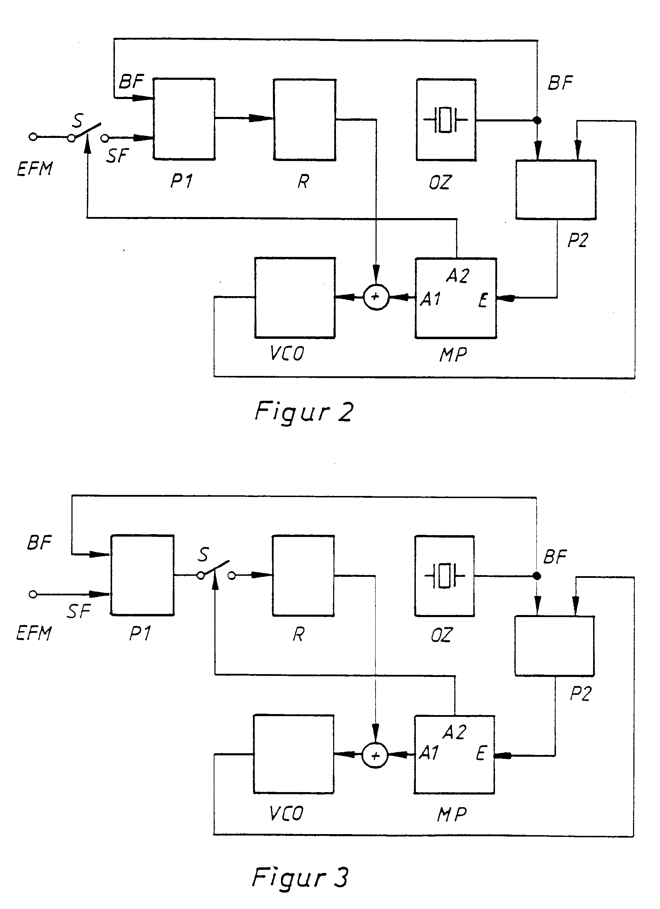

Wie in Figur 2 gezeigt ist, kann der steuerbare Schalter S vor dem ersten Eingang des Phasenvergleichers P1 oder, wie in Figur 3 dargestellt ist, zwischen dem Phasenvergleicher P1 und dem Regler R vorgesehen sein. Bei geschlossenem Schalter S ist der Ausgang des Reglers R niederohmig, bei geöffnetem Schalter S dagegen hochohmig. Daher ist der Regler R nur im ersten Fall wirksam; im zweiten Fall ist er dagegen unwirksam geschaltet.

In Figur 4 ist der erste Eingang des Phasenvergleichers P1 über die Kollektor-Emitter-Strecke eines Transistors T, dessen Basis mit dem Ausgang A2 des Mikroprozessors MP verbunden ist, mit Bezugspotential verbunden. Während des Abgleichs des Phasenregelkreises wird der Eingang des Phasenvergleichers P2 vom Transistor T auf Bezugspotential gezogen. Weil dadurch der Ausgang des Reglers R hochohmig wird, wirkt der Regler R nicht mehr auf die PLL. Er ist unwirksam geschaltet. Bei gesperrtem Transistor T ist der Regler R dagegen wirksam, weil sein Ausgang in diesem Fall niederohmig ist.

## Patentansprüche

1. Phasenregelkreis, bei dem der Ausgang eines ersten Phasenvergleichers (P1), in dem die Istfrequenz (IF) mit der Bezugsfrequenz (BF) verglichen wird, mit dem Eingang eines ersten Reglers (R) verbunden ist, dessen Ausgang mit dem Eingang eines Nachlaufoszillators (VCO) verbunden ist, **dadurch gekennzeichnet**, daß der Ausgang (A1) eines zweiten Reglers (MP) mit dem Eingang des Nachlaufoszillators (VCO) verbunden ist, daß der Ausgang des Nachlaufoszillators (VCO) mit dem ersten Eingang eines zweiten Phasenvergleichers (P2) verbunden ist, dessen zweitem Eingang die Bezugsfrequenz (BF) zugeführt wird und dessen Ausgang mit dem Eingang (E) des zweiten Reglers (MP) verbunden ist, daß zum automatischen Abgleich des Phasenregelkreises der erste Regler (R) vom Nachlaufoszillator (VCO) getrennt wird, daß der zweite Regler (MP) den Wert an seinem Ausgang (A1) so lange ändert, bis die Frequenz am Ausgang des Nachlaufoszillators (VCO) mit der Bezugsfrequenz (BF) übereinstimmt, daß nach dem Abgleich der zweite Regler (MP) diesen Wert unabhängig vom Wert am Ausgang des zweiten Phasenvergleichers (P2) beibehält und der erste Regler (R) wieder mit dem Eingang des Nachlaufoszillators (VCO) verbunden wird.

2. Phasenregelkreis nach Anspruch 1, **dadurch gekennzeichnet**, daß der Ausgang eines Quarzoszillators (OZ), der die Bezugsfrequenz (BF) erzeugt, mit dem zweiten Eingang des ersten und des zweiten Phasenvergleichers (P1, P2) verbunden ist, daß der erste Ausgang (A1) des zweiten Reglers (MP) mit dem Eingang des Nachlaufoszillators (VCO) und der zweite Ausgang (A2) des zweiten Reglers (MP) mit dem Steuereingang eines steuerbaren Schalters (S) verbunden ist, der den ersten Regler (R) unwirksam schaltet.

3. Phasenregelkreis nach Anspruch 2, **dadurch gekennzeichnet**, daß der steuerbare Schalter (S) entweder vor dem ersten Eingang des ersten Phasenvergleichers (P1) oder zwischen dem ersten Phasenvergleicher (P1) und dem ersten Regler (R) oder zwischen dem ersten Regler (R) und dem Nachlaufoszillator (VCO) liegt, daß der zweite Regler (MP) zum Abgleich des Phasenregelkreises den steuerbaren Schalter (S) öffnet und nach dem Abgleich wieder schließt.

4. Phasenregelkreis nach Anspruch 1, 2 oder 3, **dadurch gekennzeichnet**, daß der Phasenregelkreis in einem CD-Spieler aus dem EFM-Signal, das dem ersten Eingang des ersten Phasenvergleichers (P1) zugeführt wird, das Synchronsignal zur Regelung des Plattenantriebs erzeugt.

5. Phasenregelkreis nach Anspruch 4, **dadurch gekennzeichnet**, daß der Abgleich jedesmal nach dem Einschalten des CD-Spielers erfolgt.

6. Phasenregelkreis nach Anspruch 4 oder 5, **dadurch gekennzeichnet**, daß der Abgleich jedesmal vor dem Abspielen einer neuen CD-Platte erfolgt.

7. Phasenregelkreis nach Anspruch 4, 5 oder 6, **dadurch gekennzeichnet**, daß der Abgleich erfolgt, wenn keine Datensignale wiedergegeben werden.

8. Phasenregelkreis nach Anspruch 4, 5, 6 oder 7, **dadurch gekennzeichnet**, daß der Abgleich durchgeführt wird, wenn die Fehlerrate im Datensignal einen vorgebbaren Schwellwert überschreitet.

9. Phasenregelkreis nach Anspruch 4, 5, 6, 7 oder 8, **dadurch gekennzeichnet**, daß der Abgleich bei Ausfall der Datenwiedergabe erfolgt.

10. Phasenregelkreis nach Anspruch 4, 5, 6, 7, 8 oder 9, **dadurch gekennzeichnet**, daß der Abgleich während des Spurspringens erfolgt.

11. Phasenregelkreis nach Anspruch 4, 5, 6, 7, 8, 9 oder 10, **dadurch gekennzeichnet**, daß der Abgleich in der Pause zwischen zwei Musikstücken erfolgt.

12. Phasenregelkreis nach Anspruch 4, 5, 6, 7, 8, 9, 10 oder 11, **dadurch gekennzeichnet**, daß die zuletzt vor dem Abgleich eingestellte Drehzahl des Plattenantriebs für die Dauer des Abgleichs beibehalten wird.

## Claims

1. Phase control circuit, at which the output of a first phase comparator (P1), in which the actual quantity (IF) is being compared with the reference frequency (BF), is connected with the input of a first controller (R), whose output is connected with the input of a follow-up oscillator (VCO), characterized in that the output (A1) of a second controller (MP) is connected with the input of the follow-up oscillator (VCO), that the output of the follow-up oscillator (VCO) is connected with the first input of a second phase comparator (P2), to whose second input the input the reference frequency (BF) is fed to and whose output is connected with the input (E) of the second controller (MP), that for automatic alignment of the phase control circuit the first controller (R) is separated from the follow-up oscillator (VCO), that the second controller (MP) varies the value at its output (A1) for that length of time, until the frequency at the output of the follow-up oscillator (VCO) equals the reference frequency (BF), that after the alignment the second controller (MP) remains at this value independent of the value at the output of the second phase comparator (P2) and the first controller (R) will be again connected with the input of the follow-up oscillator (VCO).

2. Phase control circuit according to claim 1, characterized in that the output of a quartz oscillator (OZ), which generated the reference frequency (BF), is connected with the second input of the first and the second phase comparator (P1, P2), that the first output (A1) of the second controller (MP) is connected with the input of the follow-up oscillator (VCO) and the second output (A2) of the second controller (MP) with the control input of a controllable switch (5), who switches the first controller (R) inactive.

3. Phase control circuit according to claim 2, characterized in that the controllable switch (S) is arranged either ahead of the first input of the first phase comparator (P1) or between the first phase comparator (P1) and the first controller (R) or between the first controller (R) and the follow-up oscillator (VCO), that the second controller (MP) for alignment of the phase control circuit opens the controllable switch (S) and closed the same again after the alignment.

4. Phase control circuit according to claim 1, 2 or 3, characterized in that the phase control circuit in a CD-player generates the EFM-signal, which is fed to the first input of the first phase comparator (P1), the synchronizing signal for the control of the record drive.

5. Phase control circuit according to claim 4, characterized in that the alignment takes phase each time after starting of the CD-player.

6. Phase control circuit according to claim 4 or 5, characterized in that the alignment takes place each time before a new CD-reocrd will be reproduced.

7. Phase control circuit according to claim 4, 5 or 6, characterized in that the alignment takes place when no data signals are reproduced.

8. Phase control circuit according to claim 4, 5, 6 or 7, characterized in that the alignment takes place when the error rate of the data signal exceeds a pre-selectable threshold value.

9. Phase control circuit according to claim 4, 5, 6, 7 or 8, characterized in that the alignment takes place when failure of the data reproduction happens.

10. Phase control circuit according to claim 4, 5, 6, 7, 8 or 9, characterized in that the alignment takes place during the track jumping.

11. Phase control circuit according to claim 4, 5, 6, 7, 8, 9 or 10, characterized in that the alignment takes place within the pause between two music titles.

12. Phase control circuit according to claim 4, 5, 6, 7, 8, 9, 10 or 11, characterized in that the number of revolutions of the record drive at last adjusted before start of the alignment is being kept constant during the alignment.

## Revendications

1. Circuit de régulation de phase dans lequel la sortie d'un premier comparateur de phase (P1), dans lequel la fréquence effective (IF) est comparée à la fréquence de référence (BF), est reliée à l'entrée d'un premier régulateur (R) dont la sortie est reliée à l'entrée d'un oscillateur de poursuite (VCO), **caractérisé en ce** que la sortie (A1) d'un second régulateur (MP) est reliée à l'entrée de l'oscillateur de poursuite (VCO), que la sortie de l'oscillateur de poursuite (VCO) est reliée à la première entrée d'un second comparateur de phase (P2) à la seconde entrée duquel la fréquence de référence (BF) est amenée et dont la sortie est reliée à l'entrée (E) du second régulateur (MP), que le premier régulateur (R) est séparé de l'oscillateur de poursuite (VCO) pour l'égalisation automatique du circuit de régulation de phase, que le second régulateur (MP) varie la valeur à sa sortie (A1) jusqu'à ce que la fréquence à la sortie de l'oscillateur de poursuite (VCO) coïncide avec la fréquence de référence (BF), qu'après l'égalisation le second régulateur (MP) conserve cette valeur indépendamment de la valeur à la sortie du second comparateur de phase (P2) et que le premier régulateur (R) est à nouveau relié à l'entrée de l'oscillateur de poursuite (VCO).

2. Circuit de régulation de phase selon la revendication 1, **caractérisé en ce** que la sortie d'un oscillateur à cristal (OZ), qui produit la fréquence de référence (BF), est reliée à la seconde entrée du premier et du second comparateur de phase (P1, P2), que la première sortie (A1) du second régulateur (MP) est reliée à l'entrée de l'oscillateur de poursuite (VCO) et que la seconde sortie (A2) du second régulateur (MP) est reliée à l'entrée de commande d'un commutateur qui peut être commandé (S) qui met le premier régulateur (R) hors circuit.

3. Circuit de régulation de phase selon la revendication 2, **caractérisé en ce** que le commutateur qui peut être commandé (S) est situé soit devant la première entrée du premier comparateur de phase (P1), soit entre le premier comparateur de phase (P1) et le premier régulateur (R), soit entre le premier régulateur (R) et l'oscillateur de poursuite (VCO), que le second régulateur (MP) ouvre le commutateur qui peut être commandé (S) pour l'égalisation du circuit de régulation de phase et le referme après l'égalisation.

4. Circuit de régulation de phase selon la revendication 1, 2 ou 3, **caractérisé en ce** que le circuit de régulation de phase d'un lecteur de disques compacts produit à partir du signal de modulation de fréquence à un seul canal, qui est amené à la première entrée du premier comparateur de phase (P1), le signal de synchronisation pour le réglage de l'entraînement du disque.

5. Circuit de régulation de phase selon la revendication 4, **caractérisé en ce** que l'égalisation est effectuée à chaque fois après la mise en circuit du lecteur de disques compacts.

6. Circuit de régulation de phase selon la revendication 4 ou 5, **caractérisé en ce** que l'égalisation est effectuée chaque fois avant la lecture d'un nouveau disque compact.

7. Circuit de régulation de phase selon la revendication 4, 5 ou 6, **caractérisé en ce** que l'égalisation est effectuée lorsqu'il n'y a pas de reproduction de signaux de données.

8. Circuit de régulation de phase selon la revendication 4, 5, 6 ou 7. **caractérisé en ce** que l'égalisation est effectuée lorsque le taux d'erreurs dans le signal de données dépasse une valeur de seuil qui peut être prédéterminée.

9. Circuit de régulation de phase selon la revendication 4, 5, 6, 7 ou 8, **caractérisé en ce** que l'égalisation est effectuée lors de la défaillance de la reproduction des données.

10. Circuit de régulation de phase selon la revendication 4, 5, 6, 7, 8 ou 9, **caractérisé en ce** que l'égalisation est effectuée pendant le saut de pistes.

11. Circuit de régulation de phase selon la revendication 4, 5, 6, 7, 8, 9 ou 10, **caractérisé en ce** que l'égalisation est effectuée dans la pause entre deux morceaux de musique.

12. Circuit de régulation de phase selon la revendication 4, 5, 6, 7, 8, 9, 10 ou 11, **caractérisé en ce** que la dernière vitesse de l'entraînement du disque qui a été réglée avant l'égalisation est conservée pour la durée de l'égalisation.
